# EUROPEAN PATENT SPECIFICATION

(11) **EP 2 538 560 B1**
(45) Date of publication and mention of the grant of the patent: **24.02.2021**
(21) Application number: 11171043.0
(22) Date of filing: 22.06.2011
(51) Int. Cl.: H03K 3/356

(54) **A VOLTAGE LEVEL SHIFT CIRCUIT**
SPANNUNGSPEGELVERSCHIEBUNGSSCHALTUNG
CIRCUIT DE DÉCALAGE DE NIVEAU DE TENSION

(43) Date of publication of application: 26.12.2012
(73) Proprietor: Rohm Co., Ltd., Kyoto-shi, Kyoto 615-8585 (JP)
(72) Inventor: Kojima, Hidekazu, 40625 Duesseldorf (DE); Fronen, Robert Jan, 5391al Nuland (NL)
(74) Representative: Isarpatent

(56) References cited:
- WO-A1-95/19658
- US-A1- 2008 164 931
- US-A1- 2009 021 292
- US-A1- 2010 109 705
- US-B1- 6 838 924

## Description

The invention relates to a voltage level shift circuit as described for example in documents US 2008/0164931 A1, US 2010/0109705 A1 and WO 95/19658 for shifting a digital input signal having a narrow amplitude voltage range to a digital output signal having a wide amplitude voltage range and to a signal driver using that voltage level shift circuit for shifting a driving signal of a display.

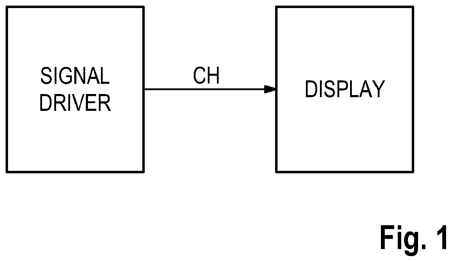

Displays can consist of a plurality of display panel elements each being driven by a driving signal. This driving signal is applied to the display panel element via a signal channel CH output by a pin of a signal driver as shown in fig. 1. The display can comprise a plurality of display panel elements DPE so that the number of signal drivers driving the display can be very high. For generating the driving signal for the display panel elements a display driver integrated circuit comprises a corresponding number of signal drivers. Each signal driver within such a display driver integrated circuit comprises several voltage level shift circuits VLSC to transfer a control signal from a digital signal domain to an analogue signal domain. A conventional display driver integrated circuit comprises in many applications voltage level shift circuits VLSC for generating a negative voltage. These negative voltage level shifters are formed by comparator level shift circuits comprising high-voltage transistors. The display can be switched between an active mode or a stand-by mode to reduce energy consumption. The conventional negative voltage level shift circuits VLSC draw an electrical current permanently during their operation. Because of the high number of required voltage level shift circuits VLSC within a signal driver integrated circuit of a display driver this has a strong impact on the total power consumption. A further disadvantage of conventional display drivers using conventional negative voltage level shift circuits VLSC is that these conventional voltage level shift circuits employ high-voltage transistors having for example a terminal-to-terminal voltage drop of 30 volts. Thus, these high-voltage transistors occupy a lot of chip area when integrated on a chip. Conventional signal drivers using a plurality of voltage level shift circuits VLSC with high-voltage transistors need a lot of chip area. Accordingly, conventional voltage level shift circuits occupy a lot of chip area because they use high-voltage transistors. Further because of their comparator structure an electrical current flows as long as a comparator enable signal applied to said voltage level shift circuit VLSC is active. In a conventional voltage level shift circuit VLSC such a comparator enable signal can last for example for a relative long time period of 0.5 us causing a high-current consumption of the conventional voltage level shift circuit VLSC. Accordingly, it is an object of the present invention to provide a negative voltage level shift circuit with a minimum current consumption and which occupies a minimum chip area in an integrated circuit.

This object is achieved by a signal driver for a display with a negative voltage level shift circuit comprising the features of claim 1.

The invention provides a signal driver for a display, said signal driver comprising: a digital control circuit providing digital signals applied to a number, NA , of positive level shift circuits and to a number, NB , of negative level shift circuits,wherein the level shift circuits are provided for shifting the digital input signals received from the digital control circuit to digital output signals applied to digital-analogue-converters supplying converted analogue output voltages via analogue output buffers and switches controlled by said digital control circuit to a digital panel element of said display driven by a driving signal voltage ranging between a negative voltage limit and a positive voltage limit,wherein the negative voltage level shift circuit is adapted to shift a narrow amplitude voltage range of the digital input signal received from the digital control circuit to a wide amplitude voltage range applied to the following digital analogue converter ,said negative voltage level shift circuit comprising counter acting bistable current branches having cascode transistors being adapted to separate an output voltage swing of said negative voltage level shift circuit from an input voltage swing of said negative voltage level shift circuit ,wherein said negative voltage level shift circuit draws a current only during a transition period in response to a data change of the digital input signal.

The negative voltage level shift circuit according to the present invention allows to shrink the chip area for a signal driver integrated circuit by up to 75 %.

Furthermore, by using the negative voltage level shift circuit according to the present invention the power consumption of a signal driver integrated circuit can be reduced by about 50 %.

A further advantage of the negative voltage level shift circuit according to the present invention is that it does not need any bias current thus reducing the power consumption and increasing its efficiency.

Furthering a possible embodiment of the negative voltage level shift circuit according to the present invention a digital input signal applied to the voltage level shift circuit comprises a voltage amplitude which is larger than or equal to a zero voltage and wherein the digital output signal output by said voltage level shift circuit comprises a voltage amplitude which is smaller than or equal to a zero voltage.

In a possible embodiment of the negative voltage level shift circuit according to the present invention the negative voltage level shift circuit comprises a boosting stage adapted to boost the amplitude of said digital input signal.

In a possible embodiment of the negative voltage level shift circuit according to the present invention said boosting stage comprises a first pair of transistors each having a control terminal for applying the digital input signal, a first terminal connected to a first reference voltage and a second terminal connected to a control terminal of a second pair of cross connected transistors each further having a first terminal connected to the second terminal of a transistor of said first pair of transistors and having a second terminal for applying a positive supply voltage to the negative voltage level shift circuit.

In a possible implementation of the negative voltage level shift circuit according to the present invention the first pair of transistors of said boosting stage comprises N-MOSFETS having an admissible terminal-to-terminal voltage drop of less than 2 volts.

In a further possible implementation of the negative voltage level shift circuit according to the present invention the second pair of transistors of said boosting stage comprises P-MOSFETS having an admissible terminal-to-terminal voltage drop of less than 2 volts.

In a possible embodiment of the negative voltage level shift circuit according to the present invention the control terminals of the second pair of transistors of said boosting stage are connected to control terminals of a pair of input transistors of the counter acting bistable current branches of said voltage level shift circuit.

In a possible embodiment of the negative voltage level shift circuit according to the present invention the pair of input transistors is connected via at least one pair of transistors connected as diodes to first terminals of a pair of cascode transistors of said counter acting bistable current branches of the voltage level shift circuit.

In a possible embodiment the control terminals of the pair of cascode transistors are connected to a second reference voltage.

In a possible embodiment of the negative voltage level shift circuit according to the present invention the second reference voltage applied to the control terminals of the pair of cascode transistors is identical with the first reference voltage connected to the first terminals of the first pair of transistors within said boosting stage of said voltage level shift circuit.

In a possible embodiment of the negative voltage level shift circuit according to the present invention the at least one pair of diode connected transistors of the counter acting bistable current branches of the voltage level shift circuit are formed by P-MOSFETS having an admissible terminal-to-terminal voltage drop of less than 7 volts.

In a possible embodiment of the negative voltage level shift circuit according to the present invention the pair of cascode transistors of said counter acting bistable current branches of said negative voltage level shift circuit are formed by N-MOSFETS having an admissible terminal-to-terminal voltage drop of less than 7 volts.

In a still further possible embodiment of the negative voltage level shift circuit according to the present invention the pair of cascode transistors further comprise second terminals connected to an output latch stage of the voltage level shift circuit.

In a possible embodiment of the negative voltage level shift circuit according to the present invention the output latch stage comprises a first pair of transistors each having a control terminal connected to a bias voltage source, a first terminal connected to a second terminal of one of said cascode transistors and a second terminal connected to a first terminal of a second pair of cross connected transistors each further having a control terminal cross connected to a second terminal of one of said cascode transistors and having a second terminal connected to a negative supply voltage of the negative voltage level shift circuit.

In a possible embodiment of the negative voltage level shift circuit according to the present invention the voltage level shift circuit comprises an output buffer circuit connected to said output latch stage of said negative voltage level shift circuit.

In a possible embodiment of the negative voltage level shift circuit according to the present invention the input transistors of said counter acting bistable current branches of said voltage level shift circuit are P-MOSFETS having an admissible terminal-to-terminal voltage drop of less than 7 Volts.

In a possible embodiment of the - negative voltage level shift circuit according to the present invention the input transistors of the counter acting bistable current branches of the negative voltage level shift circuit each comprises a high transconductance.

In a possible embodiment of the negative voltage level shift circuit according to the present invention the first pair of transistors of the output latch stage of the counter acting bistable current branches of the negative voltage level shift circuit are formed by P-MOSFETS having and admissible terminal-to-terminal voltage drop of less than 7 Volts.

In a further possible implementation of the negative voltage level shift circuit according to the present invention the second pair of transistors of the output latch stage of the counter acting bistable current branches of the negative voltage level shift circuit are formed by N-MOSFETS having an admissible terminal-to-terminal voltage drop of less than 7 Volts.

In a possible embodiment of the negative voltage level shift circuit according to the present invention the positive supply voltage which is applied to second terminals of a second pair of cross connected transistors of said boosting stage and applied to the input transistors of said counter acting bistable current branches is +1.8 Volts.

In a possible implementation of the negative voltage level shift circuit according to the present invention the negative supply voltage which is applied to the second terminals of a second pair of cross connected transistors of said output latch stage is -6 Volts.

In a possible embodiment of the negative voltage level shift circuit according to the present invention the first reference voltage has a voltage potential of 0 Volts.

In a further possible embodiment of the negative voltage level shift circuit according to the present invention the second reference voltage has a voltage potential of 0 Volts.

In the following embodiments of the negative voltage level shift circuit according to the present invention and the signal driver for a display according to the present invention comprising a negative voltage level shift circuit are described with reference to the enclosed figures in more detail.

### Brief description of the figures

- Fig. 1: shows a block diagram for illustrating a conventional signal driver generating a driving signal for a display comprising a plurality of display elements;
- Fig. 2: shows a block diagram of a possible embodiment for signal driver for a display according to the present invention comprising voltage level shift circuits for providing driving signals for display panel elements of a display;
- Figs. 3A,3B: show possible embodiments of a negative voltage level shift circuit according to the present invention as employed by the signal driver shown in fig. 2;
- Fig. 4: shows a diagram for illustrating power consumption reduction for a voltage level shift circuit according to the present invention in comparison to a conventional voltage level shift circuit;
- Fig. 5: shows a specific implementation of a circuit for generating a bias voltage applied to a voltage level shift circuit according to the present invention;
- Fig. 6: shows a possible implementation of a positive voltage level shift circuit as employed by the signal driver shown in Fig. 2.

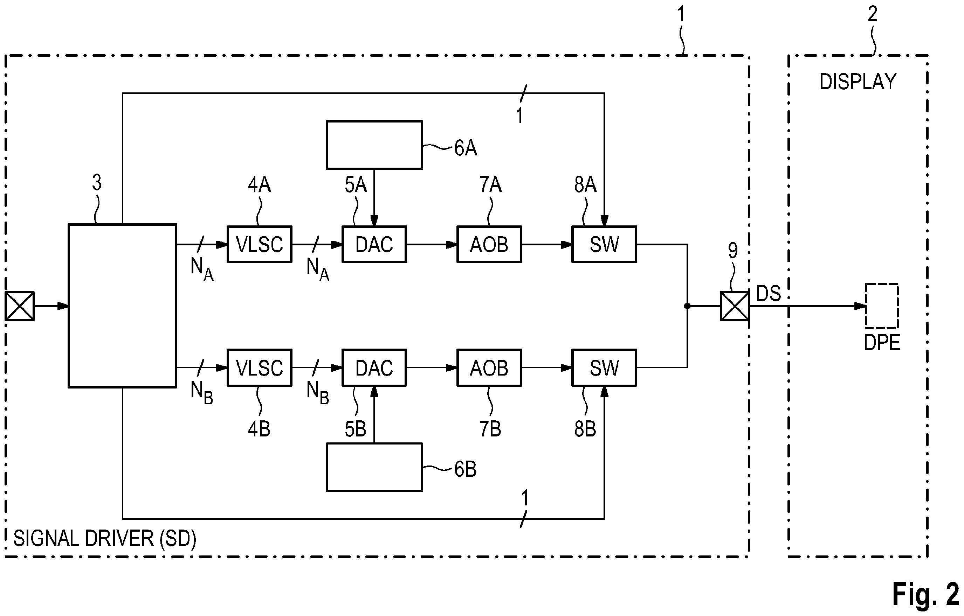

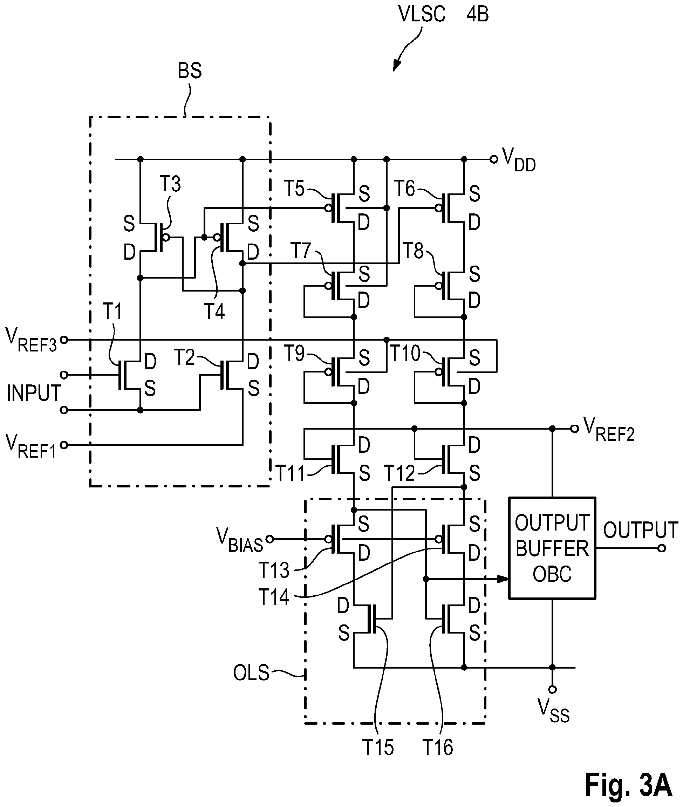

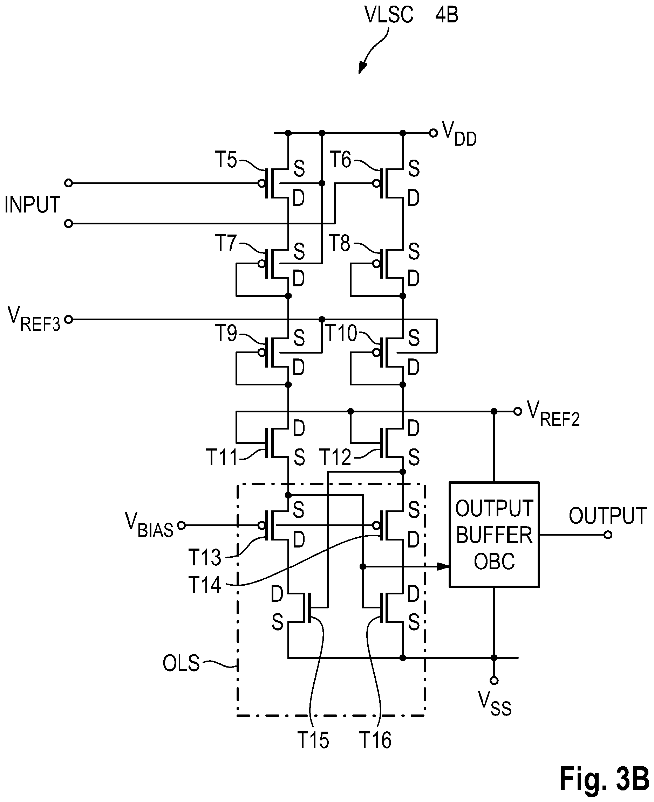

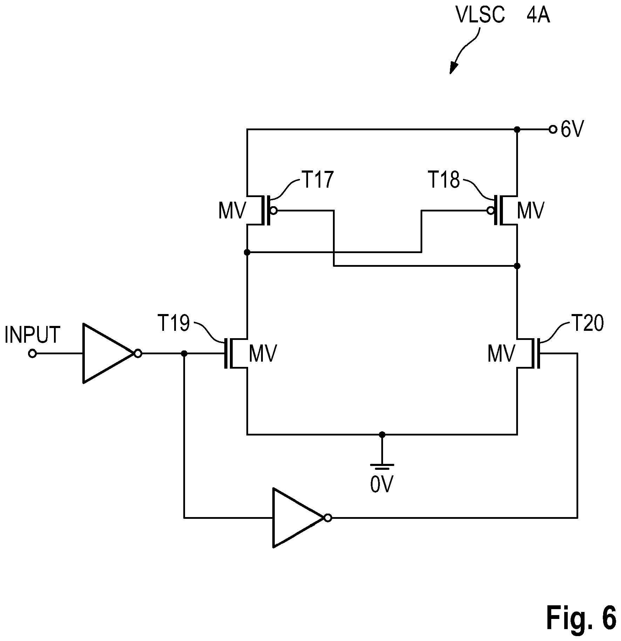

As can be seen in fig. 2 a signal driver 1 is provided for generating a driving signal for a display panel element DPE of a display 2. The signal driver 1 comprises a digital control circuit 3 having e.g. a random access memory RAM providing digital signals applied to voltage level shift circuits 4A, 4B as shown in fig. 2. In a possible implementation the display panel element DPE of the display 2 can be driven by a driving signal voltage ranging between a negative voltage limit to a positive voltage limit. For example, the display panel element DPE can be driven by a driving voltage ranging from -6 Volts to +6 Volts according to the digital values of the digital signal output by the control circuit 3. The amplitude of the applied driving signal voltage depends on the bit values of the N_{A} digital signals applied to the positive voltage level shift circuits 4A and the digital signals N_{B} applied to the negative voltage level shift circuit 4B as shown in fig. 2 as well as on the 2 bits controlling the analogue output switches 8A, 8B of the signal driver 1. In a possible implementation, N_{A} = N_{B} = 8. In this implementation the analogue driving signal voltage applied to the display panel element DPE depends on a 9 bit (N+1) value output by the digital control circuit 3. The voltage level shift circuits 4A, 4B are provided for shifting digital input signal received from the digital control circuit 3 to a digital output signal applied to a digital analogue converters 5A, 5B as shown in fig. 2. In the embodiment as shown in fig. 2 the digital analogue converters 5A, 5B are connected to gamma correction circuits 6A, 6B, respectively. The digital analogue converters 5A, 5B convert the digital output signal received from the voltage level shift circuits 4A, 4B to an analogue signal applied to an analogue output buffer 7A, 7B as shown in fig. 2. Each analogue output buffer 7A, 7B comprises in a possible embodiment an operational amplifier. The analogue output buffer 7A can be supplied in a possible embodiment by a positive supply voltage of 6 Volts and by a negative supply voltage of 0 Volt. The other analogue output buffer 7B can be supplied in a possible embodiment with a positive supply voltage of 0 Volt and a negative supply voltage of -6 Volts. The analogue output buffers 7A, 7B are connected to switches 8A, 8B being controlled by said digital control circuit 3 and being connected to a common output pin 9 to which the display 2 is attached. In a further embodiment the signal driver 1 according to the present invention as shown in fig. 2 comprises N_{B} = N negative voltage level shift circuits VLSC 4B. These negative voltage level shift circuits 4B each are provided to shift a digital input signal achieved from the digital control circuit 3 having a narrow amplitude voltage range to a digital output signal having a wide amplitude voltage range applied to the following digital analogue converter 5B. The digital input signal received by the negative voltage level shift circuit 4B comprises a voltage amplitude which is larger than or equal to zero voltage and wherein the digital output signal output by the voltage level shift circuit 4B comprises a voltage amplitude which is smaller than or equal to zero voltage. Possible embodiments of the negative voltage level shift circuit 4B are shown in figs. 3A, 3B. An example of a positive voltage level shift circuit 4A as used in the signal driver 1 is shown in fig. 6.

The negative voltage level shift circuit 4B as employed by signal driver 1 as shown in fig. 2 does comprise in a possible embodiment each counter acting bistable current branches, wherein the output voltage swing of such a voltage level shift circuit 4B is separated from an input voltage swing of the voltage level shift circuit 4B by means of cascode transistors. The voltage level shift circuits 4 used by the signal driver 1 are configured such that they draw an electrical current only during a short transmission period in response to a data change of the digital input signal applied to the voltage level shift circuit by the digital control circuit 3. The negative voltage level shift circuits 4B as used by a signal driver 1 as shown in fig. 2 do not need any bias current thus reducing power consumption significantly. The display 2 is e.g. a display of a portable device. This device can comprise at least one signal driver 1 according to the present invention.

Fig. 3A shows a possible embodiment of a negative voltage level shift circuit 4B as used by the signal driver 1 as shown in fig. 2. Fig. 3A shows a possible implementation of a negative voltage level shift circuit 4B with a negative supply voltage V_{SS} of, e.g. - 6 Volts. The voltage level shift circuit 4B as shown in fig. 3 comprises a boosting stage BS adapted to boost an amplitude of a digital input signal applied to an input of the voltage level shift circuit 4B. This digital input signal can be applied for example by a digital control circuit 3 of the signal driver 1 as shown in fig. 2. The negative voltage level shift circuit 4B as shown in fig. 3A has a first and second reference voltage V_{REF1}, V_{REF2} and can be supplied by a positive supply voltage V_{DD} and a negative supply voltage V_{SS}. Furthermore, the voltage level shift circuit 4B can receive a bias voltage V_{BIAS} applied to an output latch stage OLS of the voltage level shift circuit 4B as shown in figs. 3A, 3B. In a possible embodiment the first and second reference voltage V_{REF1} and V_{REF2} can be the same. This reference voltage can in a possible implementation comprise a voltage potential of 0 Volt. A third reference voltage V_{REF3} shown in Fig. 3A, 3B can be e.g. 1.2 Volts. The positive supply voltage VDD applied to the negative voltage level shift circuit 4B can be in a specific implementation +1.8 Volts and the negative supply voltage VSS applied to the voltage level shift circuit 4 can be in a specific implementation -6 Volts. In the embodiment shown in fig. 3A the voltage level shift circuit 4B comprises a boosting stage BS having four transistors T1, T2, T3, T4. In an alternative embodiment the voltage level shift circuit 4B as shown in fig. 3B the voltage level shift circuit 4B does not comprise a boosting stage BS and the digital input signal is directly applied to the control terminals of input transistors T5, T6. In a possible implementation the boosting stage BS as employed by the embodiment shown in Fig. 3A can be a separate circuit connected to the voltage level shift circuit 4B. In the embodiment as shown in fig. 3A the boosting stage BS is integrated in the voltage level shift circuit 4B. In the implementation as shown in fig. 3A the boosting stage BS comprises a first pair of transistors T1, T2 each having a control terminal for applying the digital input signal to the boosting stage BS at the input terminal as shown in fig. 3A. The first pair of transistors T1, T2 have a first terminal connected to a first reference voltage V_{REF1} and a second terminal connected to a control terminal of a second pair of cross connected transistors T3, T4 of the boosting stage BS. The second pair of cross connected transistors T3, T4 each have a first terminal connected directly to the second terminal of a transistor of the first pair of transistors T1, T2 of the boosting stage BS. The cross connected transistors T3, T4 further have a second terminal for applying the positive supply voltage V_{DD} of said voltage level shift circuit 4B.

In the implementation as shown in fig. 3A the first pair of transistors T1, T2 of the boosting state BS comprises N-MOSFETS. These N-MOSFETS can have an admissible terminal-to-terminal voltage drop of less than 2 volts. In the implementation as shown in fig. 3A the second pair of transistors T3, T4 of the boosting stage BS comprises P-MOSFETS. These P-MOSFETS can also have an admissible terminal-to-terminal voltage drop of less than 2 volts. Accordingly, the transistors T1, T2, T3, T4 can be classified as low-voltage transistors and can be integrated with a small chip area on an integrated circuit. Fig. 3A shows also the source and drain terminals S, D of the transistors T1, T2, T3, T4 within the boosting stage BS.

As can be seen in fig. 3A the control terminals of the second pair of cross connected transistors T3, T4 of the boosting stage BS are connected to control terminals of a pair of input transistors T5, T6 of the counter acting bistable current branches of the negative voltage level shift circuit 4B. The positive supply voltage V_{DD} of the voltage level shift circuit 4B is applied to the second terminals of the second pair of cross connected transistors T3, T4 of the boosting stage BS and also to source terminals S of the input transistors T5, T6 of the counter acting bistable current branches. The transistors T5, T6 of the counter acting bistable current branches do have a high transconductance (Iₒᵤₜ/Vᵢₙ) which can be achieved by adjusting a width/length W/L ratio of a transistor T5, T6 which is higher than of the other transistors employed in the voltage level shift circuit 4B. For fast operation during the data transition the input transistors T5, T6 are stronger than the transistors of the output latch stage OLS,i.e. they have a higher transconductance. The transconductance of the transistors is given by the ratio between the output current (Iₒᵤₜ) provided by the respective transistor and the input voltage (Vᵢₙ) applied to the transistor. The bistable current branches of the voltage level shift circuit 4B operate such that the output latch stage OLS always follows the input transistors T5, T6. For achieving a high transconductance the gate source voltage V_{GS} can be boosted in a specific implementation to 1.8 Volts. As can be seen in fig. 3A the control terminals, i.e. the gates of the second pair of cross connected transistors T3, T4 of the boosting stage BS, are connected to the control terminals, i.e. the gates of the pair of input transistors T5, T6, having a high transconductance. The pair of input transistors T5, T6 is connected via at least one pair of transistors T7, T8 and T9, T10 connected as diodes to the first terminals of control terminals of a pair of cascode transistors T11, T12 of the counter acting bistable current branches of the voltage level shift circuit 4B. As can be seen in figs. 3A, 3B the voltage level shift circuit 4B comprises two counter acting bistable current branches each having an input transistor T5 or T6, respectively. The control terminals of the pair of cascode transistors T11, T12 are connected to the second reference voltage V_{REF2} having for example a voltage potential of 0 Volts. In a possible embodiment the second reference voltage V_{REF2} applied to the control terminals of the pair of cascode transistors T11, T12 can be identical with the first reference voltage V_{REF1} connected to the first terminals of the first pair of transistors T1, T2 within the boosting stage BS. In alternative embodiments the first and second reference voltages V_{REF1}, V_{REF2} can also be different.

In the specific implementation of the voltage level shift circuit 4B as shown in the embodiment figs 3A, 3B the positive supply voltage V_{DD} is +1.8 volts, and the negative supply voltage V_{SS} is -6 volts. In case that the control input of the input transistor T5 is logical high and the control input of other input transistor T6 is logical low, output voltages at the terminals of the transistors within the output latch stage OLS are given as follows provided that the forward voltage V_{F} and the bias voltage are 0.5 Volt. In this specific implementation the voltage potential at the drain terminal D of transistor T7 is -5.5 Volts + 0.5 Volt = -5 Volts. The potential at the drain terminal D of transistor T9 is -5.5 Volts. The potential at the source terminals S of transistors T11, T13 is -6 Volts + V_{BIAS} = -6 Volts + 0.5 Volts = -5.5 Volts.

In the specific implementation the potential of the drain terminal D of transistor T8 is 1. 8 Volts - 0.5 Volts = 1.3 Volts. The potential at drain terminal D of transistor T10 is 1.3 Volts -0.5 Volts = 0.8 Volts. Further, the potential at the source terminals S of transistors T12, T14 are 0 Volt - 0.5 Volts = -0.5 Volts.

Fig. 6 shows a possible implementation of a positive voltage level shift circuit 4A as employed by the signal driver 1 of fig. 2. In the specific implementation shown in fig. 6 the positive voltage level shift circuit 4A has a positive supply voltage V_{DD} of 6 Volts and as a negative supply voltage V_{SS} of 0 Volt. The positive voltage level circuit 4A consists of two pairs of medium voltage transistors MV, i.e. a pair of cross-connected P-MOSFETS T17, T18 and a pair of N-MOSFETS T19, T20 as shown in fig. 6. The control terminals of the N-MOSFETS T19, T20 are driven by complimentary signals. The control signal of the N-MOSFET T20 generated by inverting the control signal applied to the control terminal of the N-MOSFET T19 as shown in fig. 6. The positive voltage level shift circuit 4A receives the input signal from the digital control circuit 3 as shown in fig. 2.

In a possible embodiment the at least one pair of diode connected transistors T7, T8 and T9, T10 of counter acting bistable current branches of the voltage level shift circuit 4B are formed by P-MOSFETS each having an admissible terminal-to-terminal voltage drop of less than 7 volts. In the implementations shown in fig. 3A,3B there are two pairs of diode connected transistors. The number of pairs of diode connected transistors can vary in other embodiments.

In the implementations as shown in figs. 3A, 3B the pair of cascode transistors T11, T12 of the counter acting bistable current branches are formed by N-MOSFETS. These N-MOSFETS can have in a possible embodiment an admissible terminal-to-terminal voltage drop of less than 7 volts. Accordingly, the transistors T7 - T10 as well as the cascode transistors T11, T12 can be classified as medium-voltage transistors having a terminal-to-terminal voltage drop of less than 7 volts requiring a comparatively small chip area when integrated on a chip.

The pair of cascode transistors T11, T12 comprises second terminals S (source terminals) connected to the output latch stage OLS of the voltage level shift circuit 4B. The output latch stage OLS comprises in the shown embodiment a first pair of transistors T13, T14 each having a control terminal, i.e. a gate terminal, connected to a bias voltage source, a first terminal connected to a second terminal of one of the cascode transistors T11, T12 and a second terminal connected to a first terminal of a second pair of cross connected transistors T15, T16 of the output latch stage OLS. The cross connected transistors T15, T16 further have a control terminal cross connected to a second terminal of one of the cascode transistors T11, T12 and a second terminal connected to a negative supply voltage V_{SS} of the voltage level shift circuit 4B. In the embodiments shown in figs. 3A, 3B an output buffer circuit OBC is connected to the output latch stage OLS of the voltage level shift circuit (VLSC) 4B.

The cascode transistors T11, T12 are provided to separate an output voltage swing of the voltage level shift circuit 4B from the input voltage swing of the voltage level shift circuit 4B.

In a possible embodiment the transistors T13, T14 of the output latch stage OLS can also be formed by medium voltage transistors having an admissible terminal-to-terminal voltage drop of less than 7 volts. In the implementation shown in fig. 3 the first pair of transistors T13, T14 of the output latch stage is formed by P-MOSFETS and the second pair of transistors T15, T16 of the output latch stage OLS is formed by N-MOSFETS. The negative supply voltage VSS which is applied to the second terminals of the second pair of cross connected transistors T15, T16 of the output latch stage and can in a possible implementation be -6 Volts. The voltage level shift circuit 4B as shown in figs. 3A, 3B draws an electric current only during a transmission period in response to a data change of the digital input signal applied to the input terminal of the voltage level shift circuit 4B. The voltage level shift circuit 4B as shown in figs. 3A, 3B does not consume any bias current and does consume an electrical current only during a short data transition period.

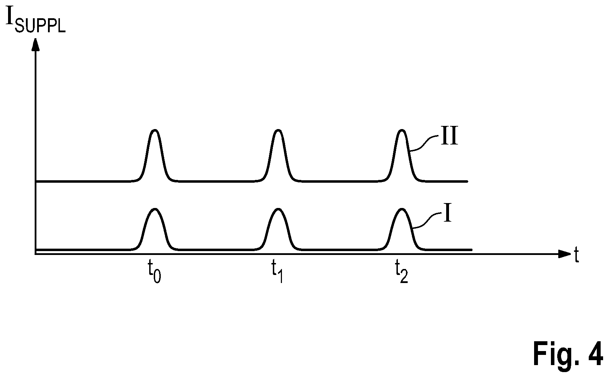

Fig. 4 shows the current consumption of a negative voltage level shift circuit 4B according to the present invention in comparison to the current consumption of a conventional negative voltage level shift circuit. At times t₀, t₁, t₂ ... a data change occurs at the digital input signal of the negative voltage level shift circuit 4B. It can be seen from curve I the voltage level shift circuit 4 according to the present invention draws only an electrical current during a short transition period when a data change of the digital input signal occurs. In contrast, a negative voltage level shift circuit 4B according to the state of the art draws a bias current also when no data change occurs and has current peaks when a data change at t₀, t₁, t₂ happens as illustrated by curve II. Accordingly, when using the voltage level shift circuit 4 according to the present invention a power consumption can be significantly reduced, in particular when a signal driver drives a plurality of negative voltage level shift circuits 4B.

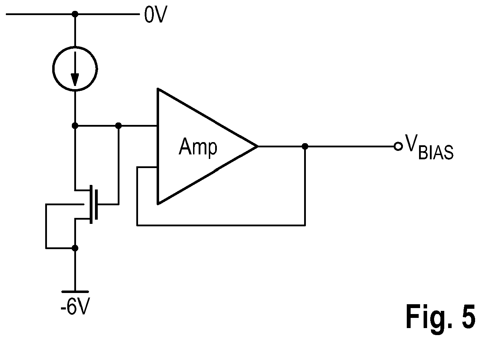

Fig. 5 shows a signal diagram for illustrating a possible implementation of the circuit for generating a bias V_{BIAS} applied to the output latch stage OLS of the negative voltage level shift circuit 4B as shown in figs. 3A, 3B. The circuit shown in fig. 4 comprises a buffer amplifier and N-MOSFET.

The signal driver comprising a voltage level shift circuit 4B according to the present invention can be used for driving any display panel and in particular can be used for display panels having display panel elements which require also a negative voltage amplitude. In a possible implementation the transistors of the voltage level shift circuit 4B can be C-MOS transistors. In a possible embodiment the signal driver 1 including the voltage level shift circuit 4B according to the present invention can be used for LCD Display. As can be seen from figs. 3A, 3B the negative voltage level shift circuit 4B according to the present invention does not comprise any high-voltage transistors but only low-voltage transistors and medium-voltage transistors. Consequently, when integrating the negative voltage level shift circuits 4B in a signal driver chip the necessary chip area is minimal so that a significant chip shrink compared to conventional signal driver integrated circuits can be achieved. In a possible embodiment the chip area can be shrinked by 75 %. Moreover, the voltage level shift circuit 4B according to the present invention does only consume an electrical current during a brief transition period when a data change occurs so that the power consumption is also reduced significantly. The power consumption can be reduced in a possible embodiment by about 50 % when compared to conventional signal driver circuits. Furthermore, the voltage level ship circuit 4B according to the present invention as shown in figs. 3A, 3B does not have to be controlled by a comparator enable control signal thus reducing the number of control signals for controlling the voltage level shift circuit. The voltage level shift circuit 4B according to the present invention comprises in the shown embodiments of figs. 3A, 3B two counter acting bistable current branches wherein the first branch consists of transistors T5, T7, T9, T11, T13, T15 and the second bistable current branch consists of transistors T6, T8, T10, T12, T14, T16. In a possible embodiment the polarity of transistors shown in figs. 3A, 3B can be inverted. The boosting stage BS circuit and the output latch stage OLS can form in a possible implementation separate circuits being not integrated in the voltage level shift circuit 4B. In this embodiment the counter acting bistable current branches can comprise only the transistors T5, T7, T9, T11 for the first branch and the transistors T6, T8, T10, T10 for the second branch. In a further implementation the reference voltages, i.e. the first reference voltage and the second reference voltage, V_{REF1}, V_{REF2} as well as the third reference voltage V_{REF3} connected to the source terminals of the transistors T9, T10 in the shown embodiment can be adapted or adjusted. In a further possible embodiment the positive supply voltage VDD and the negative supply voltage V_{SS} can also be adjusted.

## Claims

1. A signal driver (1) for a display (2),
said signal driver (1) comprising:
a digital control circuit (3) providing digital signals applied to a number, N_{A}, of positive level shift circuits (4A) and to a number, N_{B}, of negative level shift circuits (4B),
wherein the level shift circuits (4A, 4B) are provided for shifting the digital input signals received from the digital control circuit (3) to digital output signals applied to digital-analogue-converters (5A, 5B) supplying converted analogue output voltages via analogue output buffers (7A, 7B) and switches (8A, 8B) controlled by said digital control circuit (3) to a digital panel element (DPE) of said display (2) driven by a driving signal voltage (DS) ranging between a negative voltage limit and a positive voltage limit,
wherein the negative voltage level shift circuit (4B) is adapted to shift a narrow amplitude voltage range of the digital input signal received from the digital control circuit (3) to a wide amplitude voltage range applied to the following digital analogue converter (5B),
said negative voltage level shift circuit (4B) comprising counter acting bistable current branches having cascode transistors (T11, T12) being adapted to separate an output voltage swing of said negative voltage level shift circuit (4B) from an input voltage swing of said negative voltage level shift circuit (4B),
wherein said negative voltage level shift circuit (4B) draws a current only during a transition period in response to a data change of the digital input signal.

2. The signal driver according to claim 1,
wherein said digital input signal received by the negative voltage level shift circuit (4B) from the digital control circuit (3) comprises a voltage amplitude which is larger than or equal to a zero voltage and wherein said digital output signal of said negative voltage level shift circuit (4B) comprises a voltage amplitude which is smaller than or equal to a zero voltage.

3. The signal driver according to claim 1,
wherein said negative voltage level shift circuit (4B) comprises a boosting stage (BS) adapted to boost the amplitude of the digital input signal received from digital control circuit (3),
wherein said boosting stage (BS) comprises a first pair of transistors (T1, T2) each having a control terminal for applying said digital input signal, a first terminal connected to a first reference voltage (V_{REF1}) and a second terminal connected to a control terminal of a second pair of cross connected transistors (T3, T4) each further having a first terminal connected to the second terminal of a transistor of said first pair of transistors (T1, T2) and having a second terminal for applying a positive supply voltage (V_{DD}) of negative voltage level shift circuit (4B).

4. The signal driver according to claim 3,
wherein the control terminals of said second pair of transistors (T3, T4) of said boosting stage (BS) are connected to control terminals of a pair of input transistors (T5, T6) of said counter acting bistable current branches of said voltage level shift circuit (4B).

5. The signal driver according to claim 4,
wherein said pair of input transistors (T5, T6) is connected via at least one pair of transistors (T7, T8; T9, T10) connected as diodes to first terminals of a pair of cascode transistors (T11, T12) of said counter acting bistable current branches of said voltage level shift circuit (4B).

6. The signal driver according to claim 5,
wherein the control terminals of said pair of cascode transistors (T11, T12) are connected to a second reference voltage (V_{REF2}).

7. The signal driver according to claim 6,
wherein the second reference voltage (V_{REF2}) applied to the control terminals of said pair of cascode transistors (T11, T12) is identical with the first reference voltage applied to the first terminals of the first pair of transistors (T1, T2) within said boosting stage (BS).

8. The signal driver according to claim 5,
wherein said at least one pair of diode connected transistors (T7, T8; T9, T10) of said counter acting bistable current branches of said negative voltage level shift circuit (4B) are formed by P-MOSFETS having an admissible terminal-to-terminal voltage drop of less than 7 volts, and wherein said pair of cascode transistors (T11, T12) of said counter acting bistable current branches of said negative voltage level shift circuit (4B) are formed by N-MOSFETS having an admissible terminal-to-terminal voltage drop of less than 7 volts.

9. The signal driver according to one of the preceding claims 6 - 8,
wherein said pair of cascode transistors (T11, T12) further comprises second terminals connected to an output latch stage (OLS) of said negative voltage level shift circuit (4B), wherein said output latch stage (OLS) comprises a first pair of transistors (T13, T14) each having a control terminal connected to a bias voltage source, a first terminal connected to a second terminal of one of said cascode transistors (T11, T12) and a second terminal connected to a first terminal of a second pair of cross connected transistors (T15, T16) each further having a control terminal cross connected to a second terminal of one of said cascode transistors (T11, T12) and having a second terminal connected to a negative supply voltage (Vₛₛ of said negative voltage level shift circuit (4B).

10. The signal driver according to any of the preceding claims 4 or 5,
wherein the input transistors (T5, T6) of said counter acting bistable current branches of said negative voltage level shift circuit (4B) comprise a high transconductance.

11. The signal driver according to claim 3 and 9,
wherein said positive supply voltage (V_{DD}) which is applied to second terminals of a second pair of cross connected transistors (T3, T4) of said boosting stage (BS) and applied to said input transistors (T5, T6) of said counter acting bistable current branches is +1,8 volts,
wherein the negative supply voltage (Vₛₛ) which is applied to the second terminals of a second pair of cross connected transistors (T15, T16) of said output latch stage is -6 volts.

12. The signal driver according to claim 3 and 6,
wherein the first and second reference voltage (V_{REF1}, V_{REF2}) have a voltage potential of 0 volts.

## Patentansprüche

1. Signaltreiber (1) für eine Anzeige (2),
wobei der Signaltreiber (1) umfasst:
eine digitale Steuerschaltung (3), die digitale Signale bereitstellt, die an eine Anzahl (N_{A}) positiver Pegelverschiebungsschaltungen (4A) und an eine Anzahl (N_{B}) negativer Pegelverschiebungsschaltungen (4B) angelegt werden,
wobei die Pegelverschiebungsschaltungen (4A, 4B) zum Verschieben der von der digitalen Steuerschaltung (3) empfangenen digitalen Eingangssignale in digitale Ausgangssignale dienen, die in Digital-Analog-Wandler (5A, 5B) eingespeist werden, die umgewandelte analoge Ausgangsspannungen über analoge Ausgangspuffer (7A, 7B) und Schalter (8A, 8B), die durch die digitale Steuerschaltung (3) gesteuert werden, an ein digitales Paneelelement (DPE) der Anzeige (2) anlegen, das durch eine Treibersignalspannung (DS) angesteuert wird, die zwischen einer negativen Spannungsgrenze und einer positiven Spannungsgrenze liegt,
wobei die Schaltung (4B) zum Verschieben des negativen Spannungspegels dafür ausgelegt ist, einen Spannungsbereich mit schmaler Amplitude des von der digitalen Steuerschaltung (3) empfangenen digitalen Eingangssignals in einen Spannungsbereich mit breiter Amplitude zu verschieben, der an den folgenden Digitale-Analog-Wandler (5B) angelegt wird,
wobei die Schaltung (4B) zum Verschieben des negativen Spannungspegels gegenläufige bistabile Stromzweige mit Kaskodentransistoren (T11, T12) umfasst, die dafür ausgelegt sind, einen Ausgangsspannungshub der Schaltung (4B) zum Verschieben des negativen Spannungspegels von einem Eingangsspannungshub der Schaltung (4B) zum Verschieben des negativen Spannungspegels zu trennen,
wobei die Schaltung (4B) zum Verschieben des negativen Spannungspegels nur während eines Übergangszeitraums in Reaktion auf eine Datenänderung des digitalen Eingangssignals einen Strom zieht.

2. Signaltreiber nach Anspruch 1,
wobei das digitale Eingangssignal, das durch die Schaltung (4B) zum Verschieben des negativen Spannungspegels von der digitalen Steuerschaltung (3) empfangen wird, eine Spannungsamplitude umfasst, die mindestens so groß wie eine Nullspannung ist, und wobei das digitale Ausgangssignal der Schaltung (4B) zum Verschieben des negativen Spannungspegels eine Spannungsamplitude umfasst, die maximal so groß wie eine Nullspannung ist.

3. Signaltreiber nach Anspruch 1,
wobei die Schaltung (4B) zum Verschieben des negativen Spannungspegels eine Verstärkungsstufe (BS) umfasst, die dafür ausgelegt ist, die Amplitude des von der digitalen Steuerschaltung (3) empfangenen digitalen Eingangssignals zu verstärken,
wobei die Verstärkungsstufe (BS) ein erstes Paar Transistoren (T1, T2) umfasst, die jeweils aufweisen:
einen Steuerungsanschluss zum Anlegen des digitalen Eingangssignals, einen ersten Anschluss, der mit einer ersten Referenzspannung (V_{REF1}) verbunden ist, und einen zweiten Anschluss, der mit einem Steuerungsanschluss eines zweiten Paares kreuzgeschalteter Transistoren (T3, T4) verbunden ist, die des Weiteren jeweils einen ersten Anschluss aufweisen, der mit dem zweiten Anschluss eines Transistors des ersten Paares Transistoren (T1, T2) verbunden ist, und einen zweiten Anschluss zum Anlegen einer positiven Versorgungsspannung (V_{DD}) einer Schaltung (4B) zum Verschieben eines negativen Spannungspegels aufweisen.

4. Signaltreiber nach Anspruch 3,
wobei die Steuerungsanschlüsse des zweiten Paares Transistoren (T3, T4) der Verstärkungsstufe (BS) mit Steuerungsanschlüssen eines Paares Eingangstransistoren (T5, T6) der gegenläufigen bistabilen Stromzweige der Spannungspegelverschiebungsschaltung (4B) verbunden sind.

5. Signaltreiber nach Anspruch 4,
wobei das Paar Eingangstransistoren (T5, T6) über mindestens ein Paar Transistoren (T7, T8; T9, T10), die als Dioden geschaltet sind, mit ersten Anschlüssen eines Paares Kaskodentransistoren (T11, T12) der gegenläufigen bistabilen Stromzweige der Spannungspegelverschiebungsschaltung (4B) verbunden ist.

6. Signaltreiber nach Anspruch 5,
wobei die Steuerungsanschlüsse des Paares Kaskodentransistoren (T11, T12) mit einer zweiten Referenzspannung (V_{REF2}) verbunden sind.

7. Signaltreiber nach Anspruch 6,
wobei die zweite Referenzspannung (V_{REF2}), die an die Steuerungsanschlüsse des Paares Kaskodentransistoren (T11, T12) angelegt wird, mit der ersten Referenzspannung identisch ist, die an die ersten Anschlüsse des ersten Paares Transistoren (T1, T2) innerhalb der Verstärkungsstufe (BS) angelegt wird.

8. Signaltreiber nach Anspruch 5,
wobei das mindestens eine Paar diodengeschalteter Transistoren (T7, T8; T9, T10) der gegenläufigen bistabilen Stromzweige der Schaltung (4B) zum Verschieben des negativen Spannungspegels durch P-MOSFETS gebildet wird, die einen zulässigen Spannungsabfall von Anschluss zu Anschluss von weniger als 7 Volt aufweisen, und
wobei das Paar Kaskodentransistoren (T11, T12) der gegenläufigen bistabilen Stromzweige der Schaltung (4B) zum Verschieben des negativen Spannungspegels durch N-MOSFETS gebildet wird, die einen zulässigen Spannungsabfall von Anschluss zu Anschluss von weniger als 7 Volt aufweisen.

9. Signaltreiber nach einem der vorangehenden Ansprüche 6-8, wobei das Paar Kaskodentransistoren (T11, T12) des Weiteren zweite Anschlüsse umfasst, die mit einer Ausgangs-Latch-Stufe (Output Latch Stage, OLS) der Schaltung (4B) zum Verschieben des negativen Spannungspegels verbunden sind,
wobei die Ausgangs-Latch-Stufe (OLS) ein erstes Paar Transistoren (T13, T14) umfasst, die jeweils aufweisen:
einen Steuerungsanschluss, der mit einer Vorspannungsquelle verbunden ist, einen ersten Anschluss, der mit einem zweiten Anschluss eines der Kaskodentransistoren (T11, T12) verbunden ist, und einen zweiten Anschluss, der mit einem ersten Anschluss eines zweiten Paares kreuzgeschalteter Transistoren (T15, T16) verbunden ist, die des Weiteren jeweils einen Steuerungsanschluss aufweisen, der mit einem zweiten Anschluss eines der Kaskodentransistoren (T11, T12) kreuzgeschaltet ist, und einen zweiten Anschluss aufweisen, der mit einer negativen Versorgungsspannung (Vss) der Schaltung (4B) zum Verschieben des negativen Spannungspegels verbunden ist.

10. Signaltreiber nach einem der vorangehenden Ansprüche 4 und 5,
wobei die Eingangstransistoren (T5, T6) der gegenläufigen bistabilen Stromzweige der Schaltung (4B) zum Verschieben des negativen Spannungspegels eine hohe Transkonduktanz aufweisen.

11. Signaltreiber nach Anspruch 3 und 9,
wobei die positive Versorgungsspannung (V_{DD}), die an zweite Anschlüsse eines zweiten Paares kreuzgeschalteter Transistoren (T3, T4) der Verstärkungsstufe (BS) angelegt wird und an die Eingangstransistoren (T5, T6) der gegenläufigen bistabilen Stromzweige angelegt wird, +1,8 Volt beträgt,
wobei die negative Versorgungsspannung (V_{SS}), die an die zweiten Anschlüsse eines zweiten Paares kreuzgeschalteter Transistoren (T15, T16) der Ausgangs-Latch-Stufe angelegt wird, -6 Volt beträgt.

12. Signaltreiber nach Anspruch 3 und 6,
wobei die erste und die zweite Referenzspannung (V_{REF1}, V_{REF2}) ein Spannungspotential von 0 Volt aufweisen.

## Revendications

1. Pilote de signal (1) pour un écran (2),
ledit pilote de signal (1) comprenant :
un circuit de commande numérique (3) fournissant des signaux numériques appliqués à un certain nombre, N_{A}, de circuits de décalage de niveau positifs (4A) et à un certain nombre, N_{B}, de circuits de décalage de niveau négatifs (4B), dans lequel les circuits de décalage de niveau (4A, 4B) sont prévus pour changer les signaux d'entrée numériques reçus à partir du circuit de commande numérique (3) en signaux de sortie numériques appliqués à des convertisseurs numériques/analogiques (5A, 5B) fournissant des tensions de sortie analogiques converties via des tampons de sortie analogiques (7A, 7B) et des commutateurs (8A, 8B) commandés par ledit circuit de commande numérique (3) à un élément de panneau numérique (DPE) dudit écran (2) attaqué par une tension de signal d'attaque (DS) comprise entre une limite de tension négative et une limite de tension positive,
dans lequel le circuit de décalage de niveau de tension négative (4B) est conçu pour changer une plage de tension d'amplitude étroite du signal d'entrée numérique reçu à partir du circuit de commande numérique (3) en une plage de tension d'amplitude large appliquée au convertisseur analogique numérique suivant (5B),
ledit circuit de décalage de niveau de tension négative (4B) comprenant des branches de courant bistables à contre-réaction ayant des transistors cascodes (T11, T12) conçus pour séparer une oscillation de tension de sortie dudit circuit de décalage de niveau de tension négative (4B) d'une oscillation de tension d'entrée dudit circuit de décalage de niveau de tension négative (4B),
dans lequel ledit circuit de décalage de niveau de tension négative (4B) absorbe un courant uniquement pendant une période de transition en réponse à un changement de données du signal d'entrée numérique.

2. Pilote de signal selon la revendication 1,
dans lequel ledit signal d'entrée numérique reçu par le circuit de décalage de niveau de tension négative (4B) à partir du circuit de commande numérique (3) comprend une amplitude de tension qui est supérieure ou égale à une tension nulle, et dans lequel ledit signal de sortie numérique dudit circuit de décalage de niveau de tension négative (4B) comprend une amplitude de tension qui est inférieure ou égale à une tension nulle.

3. Pilote de signal selon la revendication 1,
dans lequel ledit circuit de décalage de niveau de tension négative (4B) comprend un étage d'amplification (BS) prévu pour amplifier l'amplitude du signal d'entrée numérique reçu à partir du circuit de commande numérique (3), dans lequel ledit étage d'amplification (BS) comprend une première paire de transistors (T1, T2) ayant chacun une borne de commande pour appliquer ledit signal d'entrée numérique, une première borne connectée à une première tension de référence (V_{REF1}) et une seconde borne connectée à une borne de commande d'une seconde paire de transistors interconnectés (T3, T4) ayant chacun en outre une première borne connectée à la seconde borne d'un transistor de ladite première paire de transistors (T1, T2) et ayant une seconde borne pour appliquer une tension d'alimentation positive (V_{DD}) du circuit de décalage de niveau de tension négative (4B).

4. Pilote de signal selon la revendication 3,
dans lequel les bornes de commande de ladite seconde paire de transistors (T3, T4) dudit étage d'amplification (BS) sont connectées à des bornes de commande d'une paire de transistors d'entrée (T5, T6) desdites branches de courant bistables à contre-réaction dudit circuit de décalage de niveau de tension (4B).

5. Pilote de signal selon la revendication 4,
dans lequel ladite paire de transistors d'entrée (T5, T6) est connectée via au moins une paire de transistors (T7, T8; T9, T10) connectés en tant que diodes à de premières bornes d'une paire de transistors cascodes (T11, T12) desdites branches de courant bistables à contre-réaction dudit circuit de décalage de niveau de tension (4B).

6. Pilote de signal selon la revendication 5,
dans lequel les bornes de commande de ladite paire de transistors cascodes (T11, T12) sont connectées à une seconde tension de référence (V_{REF2}) .

7. Pilote de signal selon la revendication 6,
dans lequel la seconde tension de référence (V_{REF2}) appliquée aux bornes de commande de ladite paire de transistors cascodes (T11, T12) est identique à la première tension de référence appliquée aux premières bornes de la première paire de transistors (T1, T2) dans ledit étage d'amplification (BS).

8. Pilote de signal selon la revendication 5,
dans lequel ladite au moins une paire de transistors connectés en diodes (T7, T8; T9, T10) desdites branches de courant bistables à contre-réaction dudit circuit de décalage de niveau de tension négative (4B) sont formés par des P-MOSFETS ayant une chute de tension admissible de borne à borne inférieure à 7 volts, et
dans lequel ladite paire de transistors cascodes (T11, T12) desdites branches de courant bistables à contre-réaction dudit circuit de décalage de niveau de tension négative (4B) sont formés par des N-MOSFETS ayant une chute de tension admissible de borne à borne de moins de 7 volts.

9. Pilote de signal selon l'une des revendications 6 à 8 précédentes,
dans lequel ladite paire de transistors cascodes (T11, T12) comprend en outre de secondes bornes connectées à un étage de verrouillage de sortie (OLS) dudit circuit de décalage de niveau de tension négative (4B),
dans lequel ledit étage de verrouillage de sortie (OLS) comprend une première paire de transistors (T13, T14) ayant chacun une borne de commande connectée à une source de tension de polarisation, une première borne connectée à une seconde borne de l'un desdits transistors cascodes (T11, T12) et une seconde borne connectée à une première borne d'une seconde paire de transistors interconnectés (T15, T16) ayant chacun en outre une borne de commande interconnectée à une seconde borne de l'un desdits transistors cascodes (T11, T12) et ayant une seconde borne connecté à une tension d'alimentation négative (Vss) dudit circuit de décalage de niveau de tension négative (4B) .

10. Pilote de signal selon l'une quelconque des revendications 4 ou 5 précédentes,
dans lequel les transistors d'entrée (T5, T6) desdites branches de courant bistables à contre-réaction dudit circuit de décalage de niveau de tension négative (4B) comprennent une transconductance élevée.

11. Pilote de signal selon les revendications 3 et 9, dans lequel ladite tension d'alimentation positive (V_{DD}) qui est appliquée à de secondes bornes d'une seconde paire de transistors interconnectés (T3, T4) dudit étage d'amplification (BS) et appliquée auxdits transistors d'entrée (T5, T6) desdites branches de courant bistables à contre-réaction est de +1,8 volt,
dans lequel la tension d'alimentation négative (Vss) qui est appliquée aux secondes bornes d'une seconde paire de transistors interconnectés (T15, T16) dudit étage de verrouillage de sortie est de -6 volts.

12. Pilote de signal selon les revendications 3 et 6, dans lequel la première et la seconde tension de référence (V_{REF1}, V_{REF2}) ont un potentiel de tension de 0 volt.
